# EUROPEAN PATENT APPLICATION

(11) **EP 4 773 176 A1**
(43) Date of publication of application: **08.07.2026**
(21) Application number: 24889224.2
(22) Date of filing: 29.08.2024
(51) Int. Cl.: H01L 21/67, B08B 5/02, B08B 5/04, B08B 7/00, H01L 23/00, G03F 1/82

(54) **CLEANER DEVICE**

(30) Priority: 06.11.2023 KR 20230151605; 05.08.2024 KR 20240103974
(71) Applicant: Cowindst Co., Ltd., Pyeongtaek-si, Gyeonggi-do 17708 (KR)
(72) Inventor: KIM, Seon Joo, Anyang-si, Gyeonggi-do 14090 (KR); LEE, Jin Won, Hwaseong-si, Gyeonggi-do 18374 (KR); SEONG, Myung Jun, Incheon 21022 (KR); CHO, Deuk Ho, Uiwang-si, Gyeonggi-do 16103 (KR); PARK, Hoon, Anyang-si, Gyeonggi-do 13928 (KR)
(74) Representative: Kim Kang, Jae Hee
(86) International application number: PCT/KR2024/096106
(87) International publication number: WO 2025/101038

(57) **Abstract**

A cleaning apparatus according to an embodiment of the present invention may comprise: a camera unit configured to capture an image of a surface of a flat substrate including a wafer or a mask; a laser unit configured to irradiate a laser beam onto a target position when a target position to which a foreign material is attached is identified through the camera unit; a cleaning unit configured to spray gas toward the target position and a surrounding region thereof; and a suction unit configured to suction floating materials generated by the laser unit and/or the cleaning unit.

## Description

### TECHNICAL FIELD

The present invention relates to a cleaning apparatus, and more particularly, to a cleaning apparatus configured to remove foreign materials while simultaneously cooling a flat substrate including a wafer or a mask.

### BACKGROUND ART

Recently, in accordance with trends toward enhanced functionality and improved portability of electronic devices, stacked semiconductor devices, in which a plurality of semiconductor chips or semiconductor packages are stacked using bonding technology, have been widely used.

Here, a bump is an external connection terminal formed of an electrically conductive metallic material on a surface of a wafer. The bump serves as a passage for electrically connecting circuits of different semiconductor chips.

However, when foreign materials are attached to a surface of the wafer or to bumps during a manufacturing process of the stacked semiconductor device, problems may arise during a stacking process or an operating process. Conventionally, when damage to a bump occurs during the manufacturing process of the stacked semiconductor device, the foreign material is removed manually, or the product is discarded without undergoing a foreign material removal process. As a result, there have been problems in that product yield is reduced and substantial manufacturing cost loss is incurred due to disposal.

Further, even in the case of a mask including a photomask or the like, there is a need for a more improved cleaning apparatus.

### DETAILED DESCRIPTION OF THE INVENTION

### Technical Tasks

Embodiments of the present invention have been devised to solve the above-described problems, and an object of the present invention is to provide a cleaning apparatus capable of removing foreign materials attached to a surface of a flat substrate including a wafer or a mask and to bumps.

Another object of the present invention is to provide a cleaning apparatus capable of cooling the surface of a flat substrate including a wafer or a mask simultaneously with removal of foreign materials.

Another object of the present invention is to provide a cleaning apparatus configured such that floating materials generated during a foreign material removal process do not remain on the surface of a flat substrate including a wafer or a mask.

Another object of the present invention is to provide a cleaning apparatus capable of removing foreign materials in different manners according to a type of the foreign material.

### Technical Solutions

In order to solve the above-described problems, an embodiment of the present invention provides a cleaning apparatus comprising: a camera unit configured to capture an image of a surface of a flat substrate including a wafer or a mask; a laser unit configured to irradiate a laser beam onto a target position when a target position to which a foreign material is attached is identified through the camera unit; a cleaning unit configured to spray gas toward the target position and a surrounding region thereof; and a suction unit configured to suction floating materials generated by the laser unit and/or the cleaning unit.

Preferably, the cleaning unit is configured to detach the foreign material by rapidly contracting and subsequently rapidly expanding the foreign material through physical collision therewith.

Preferably, the cleaning unit is configured to remove organic foreign materials, and the laser unit is configured to remove foreign materials including organic foreign materials that are not removed by the cleaning unit.

Preferably, during a foreign material removal process performed by the laser unit, the cleaning unit is configured to spray solid-state carbon dioxide to cool the flat substrate and to simultaneously blow away floating materials generated during the foreign material removal process while preventing thermal damage to the flat substrate.

Preferably, the cleaning apparatus further comprises an objective lens unit disposed on an optical path on which an optical axis of the laser unit and an optical axis of the camera unit coincide.

Preferably, one side of the suction unit includes a suction portion recessed inwardly and having a circular cross section so that floating materials are radially drawn into the suction portion.

Preferably, a center of an inner diameter of the suction portion is disposed on an optical path of the camera unit, and the cleaning unit is disposed to face the suction portion and is configured to spray solid-state carbon dioxide toward the suction portion during operation of the suction unit.

### Effects of the Invention

According to the technical solutions of the present invention as described above, various effects including the following may be obtained. However, the present invention is not limited to embodiments exhibiting all of the following effects.

According to an embodiment of the present invention, the cleaning apparatus may remove foreign materials attached to a surface of a flat substrate including a wafer or a mask and to bumps, thereby increasing product yield and reducing loss costs due to disposal.

Further, the present invention may cool the surface of a flat substrate including a wafer or a mask simultaneously with removal of foreign materials, thereby preventing damage caused by heat.

Further, the present invention may prevent floating materials generated during the foreign material removal process from remaining on the surface of a flat substrate including a wafer or a mask, thereby preventing errors caused by the floating materials.

Further, the present invention may remove foreign materials in different manners according to the type of foreign material, thereby effectively removing each type of foreign material.

### BRIEF DESCRIPTION OF THE DRAWINGS

FIG. 1 is a schematic view of a cleaning apparatus according to an embodiment of the present invention.
FIG. 2 is an enlarged schematic view of a portion of the cleaning apparatus of FIG. 1.
FIG. 3 is a photograph showing organic foreign materials attached to a surface of a flat substrate including a wafer or a mask.
FIG. 4 is a photograph showing metallic foreign materials attached to a surface of a flat substrate including a wafer or a mask.
FIG. 5 is a schematic view showing an operating manner of the laser unit of FIG. 1.
FIG. 6 is a schematic view showing an operating manner of the cleaning unit of FIG. 1.
FIG. 7 is a photograph comparing surface states of a flat substrate including a wafer or a mask before and after operation of the suction unit of FIG. 1.
FIG. 8 is a schematic top view of FIG. 2.

### EMBODIMENTS FOR IMPLEMENTING THE INVENTION

In order to facilitate a sufficient understanding of the configurations and advantages of the present disclosure, preferred embodiments of the present disclosure will be described with reference to the accompanying drawings. However, the present disclosure is not limited to the embodiments disclosed herein and may be embodied in various forms with various modifications. In the following description of the present invention, detailed descriptions of well-known functions and configurations will be omitted when it is determined that they may unnecessarily obscure the gist of the present invention to the person skilled in the art.

Terms such as "first," "second," and the like may be used herein to describe various elements, but such elements should not be limited by these terms. These terms are used merely to distinguish one element from another. For example, without departing from the scope of the present invention, a first element may be referred to as a second element, and similarly a second element may be referred to as a first element.

As used herein, terms such as "comprise," "include," or the like are intended to specify the presence of stated features, integers, steps, operations, elements, components, or combinations thereof, but do not preclude the presence or addition of one or more other features, integers, steps, operations, elements, components, or combinations thereof.

Terms used herein are used only for the purpose of describing particular embodiments and are not intended to limit the present invention. Unless the context clearly indicates otherwise, singular forms include plural forms as well. Unless otherwise defined, terms used herein should be interpreted as having meanings commonly understood by those skilled in the art to which the present invention pertains.

Hereinafter, specific embodiments of the present invention will be described in detail with reference to the accompanying drawings.

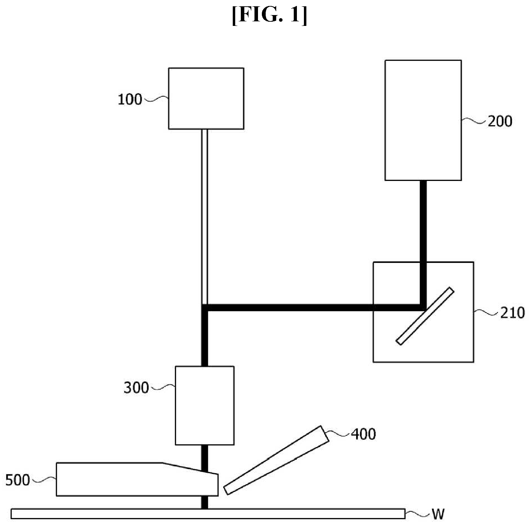

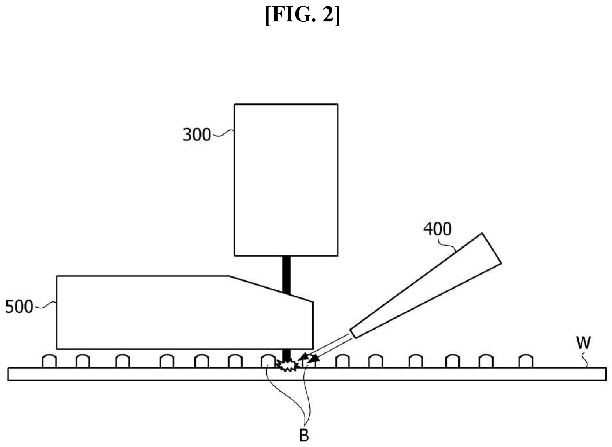

FIG. 1 is a schematic view of a cleaning apparatus according to an embodiment of the present invention, and FIG. 2 is an enlarged schematic view of a portion of the cleaning apparatus of FIG. 1. The present invention may include an inspection unit (not shown), a movement unit (not shown), a camera unit 100, a laser unit 200, an objective lens unit 300, a cleaning unit 400, a suction unit 500, and the like.

The inspection unit may inspect contamination, foreign materials C, and defects on a surface of a flat substrate W including a wafer or a mask. Here, the foreign materials C may include metallic foreign materials, organic foreign materials, and the like. The mask includes a photomask and the like. Foreign materials in the atmosphere may be attached to the mask. When the foreign materials C are detected, the inspection unit may transmit, to the movement unit, address data including coordinates of a target position at which the foreign materials C are detected. The movement unit having received the address data may move to the corresponding coordinates. Meanwhile, a position of the movement unit may be manually adjusted by an operator. In one embodiment, the movement unit may move the camera unit 100, the laser unit 200, the objective lens unit 300, the cleaning unit 400, the suction unit 500, and the like.

The camera unit 100 may capture an image of the surface of the flat substrate W including a wafer or a mask. In one embodiment, the camera unit 100 may capture an image of the surface of the flat substrate W including a wafer or a mask at a predetermined magnification. The camera unit 100 may acquire a captured image by guiding illumination light reflected from the foreign materials C or the like through an image lens (not shown). At this time, the camera unit 100 may be electrically connected to a display device such as a monitor, and may transmit the captured image to the display device in real time.

The laser unit 200 generates a laser beam L having a predetermined wavelength, pulse width, and output conditions. The laser unit 200 may generate a single-pulse laser beam L or a multi-pulse laser beam L. The laser beam L may be appropriately selected depending on the type of foreign materials C. The number of laser beams L oscillated through the laser unit 200 may be one.

In one embodiment, the present invention may further include a beam shaper portion (not shown), a laser scanner portion 210, and the like. The beam shaper portion may control a shape and size of the laser beam L. The laser scanner portion 210 may adjust an optical axis of the laser beam L such that the laser beam L is irradiated onto a preset position.

Meanwhile, the objective lens unit 300 may condense the laser beam L. In one embodiment, the objective lens unit 300 may be disposed on an optical path on which an optical axis of the laser unit 200 and an optical axis of the camera unit 100 coincide. As a result, a single objective lens unit 300 shared by the laser unit 200 and the camera unit 100 is used in the present apparatus. For this purpose, the objective lens unit 300 may include a revolver portion (not shown) in which a plurality of camera-unit lenses having different magnifications and a lens for the laser unit are arranged. In one embodiment, the revolver portion is configured such that a plurality of lenses are arranged in a line and exchanged in a linear manner. This allows the laser unit 200 to irradiate the laser beam L onto the same position as the position captured by the camera unit 100.

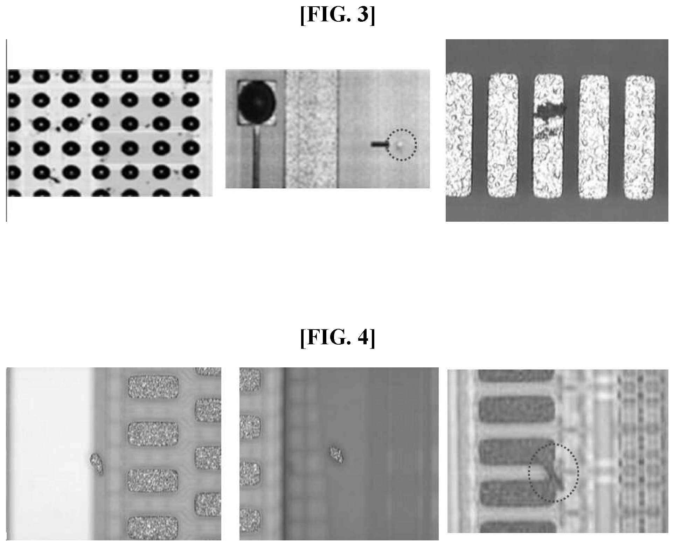

FIGS. 3 and 4 are photographs of organic foreign materials C and metallic foreign materials C attached to the surface and bumps B of the flat substrate W including a wafer or a mask, as captured through the camera unit 100. In one embodiment according to the present invention, the organic foreign materials C may be removed by the cleaning unit 400, and the foreign materials C including organic foreign materials not removed by the cleaning unit and metallic foreign materials and the like may preferably be removed by the laser unit 200.

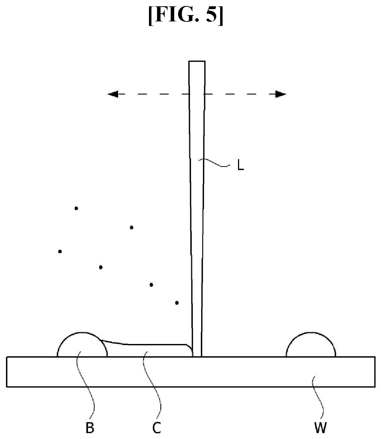

In one embodiment, when a target position to which the foreign materials C are attached is identified through the camera unit 100, the laser unit 200 may irradiate the laser beam L onto the target position. FIG. 5 is a schematic view showing an operating manner of the laser unit 200 of FIG. 1. Referring to FIG. 5, when the foreign material has a size equal to or greater than a predetermined size, the laser beam L may be scanned linearly from one point of the foreign material to another point thereof. Meanwhile, when the foreign material C is attached to a certain point, the laser beam L may be point-irradiated onto the corresponding point. In this case, the foreign materials C irradiated by the laser unit 200 may include a metallic residual film, metallic foreign materials, organic foreign materials, and the like. Meanwhile, floating materials may be generated during a process of removing the foreign materials C using the laser beam L.

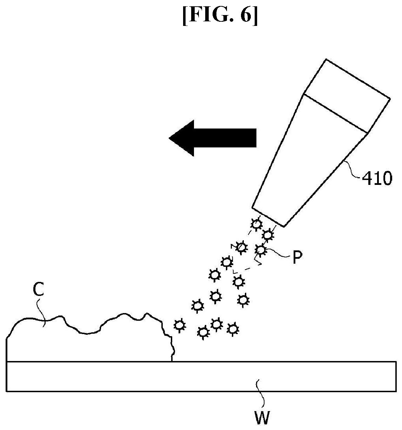

FIG. 6 is a schematic view showing an operating manner of the cleaning unit 400 of FIG. 1. Referring to FIG. 6, the cleaning unit 400 may include an injection nozzle 410 configured to spray gas. In one embodiment, the cleaning unit 400 may spray gas toward the target position and a surrounding region thereof. Here, the gas may be a cooling gas. In one embodiment, the cooling gas is sprayed at high pressure and may include solid-state CO2 pellets. Further, the CO2 pellets P are preferably solid-state carbon dioxide (dry ice) formed to have a size on the order of several micrometers to several tens of micrometers.

In one embodiment, the cleaning unit 400 may detach the foreign materials C by rapidly contracting and subsequently rapidly expanding the foreign materials C through physical collision therewith. In this case, the foreign materials C are preferably organic foreign materials.

The detachment process of the foreign materials C will now be described in more detail. CO2 pellets P having a temperature in a range of -70° C to -80° C freeze the foreign materials C while colliding with the foreign materials C. During that process, cracks are generated as the foreign materials C rapidly contract due to a temperature difference with the surroundings. At this time, the CO2 pellets P sprayed at a high speed may partially enter gaps between the cracks of the foreign materials C. Alternatively, the CO2 pellets P may partially enter a gap between the foreign materials C and the flat substrate W including a wafer or a mask. The CO2 pellets P that enter the foreign materials C are sublimated and, in one embodiment, may expand in volume by 800 times or more.

Meanwhile, since the CO2 pellets P sublime into gas at room temperature, secondary contamination caused by the cooling gas itself may be prevented. As the CO2 pellets P expand, the foreign materials C may be broken by an expansion force or separated from the surface of the flat substrate W including a wafer or a mask. The cleaning unit 400 may repeat this process to remove the foreign materials C attached to the surface of the flat substrate W including a wafer or a mask. Meanwhile, floating materials may be generated during the process of removing the foreign materials C by the cleaning unit 400.

According to one embodiment of the present invention, during a foreign material removal process performed by the laser unit 200, the cleaning unit 400 may be configured to spray solid-state carbon dioxide to cool the flat substrate W including a wafer or a mask and to simultaneously blow away floating materials generated during the foreign material removal process while preventing thermal damage to the flat substrate W including a wafer or a mask.

In one embodiment, during the foreign material removal process performed by the laser unit 200, the suction unit 500 and the cleaning unit 400 may be operated simultaneously. In one embodiment, the CO2 pellets P may function as both a cooling gas and a blowing gas. As a result, the suction unit 500 according to one embodiment preferably does not include a separate blowing nozzle.

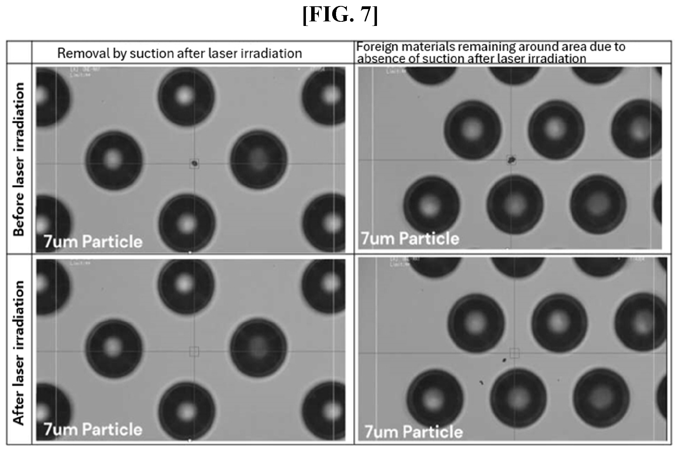

FIG. 7 is a photograph comparing surface states of the flat substrate W including a wafer or a mask before and after operation of the suction unit 500 of FIG. 1. Referring to FIG. 7, it can be observed that floating materials remain on the surface of the flat substrate W including a wafer or a mask before the suction unit 500 is operated.

In one embodiment, the suction unit 500 may suction floating materials generated by the laser unit 200 and/or the cleaning unit 400. In this case, the suction unit 500 is operated simultaneously with the laser unit 200 and/or the cleaning unit 400 so that the floating materials are prevented from being reattached to the surface of the flat substrate W including a wafer or a mask. In this case, the suction unit 500 may be disposed between the objective lens unit 300 and the flat substrate W including a wafer or a mask. The suction unit 500 may preferably have a spacing from the flat substrate W including a wafer or a mask within a preset range.

Meanwhile, the suction unit 500 may include a suction portion 510 configured to suction air at the target position and a surrounding region thereof. In one embodiment, the suction portion 510 may be formed on one side of the suction unit 500.

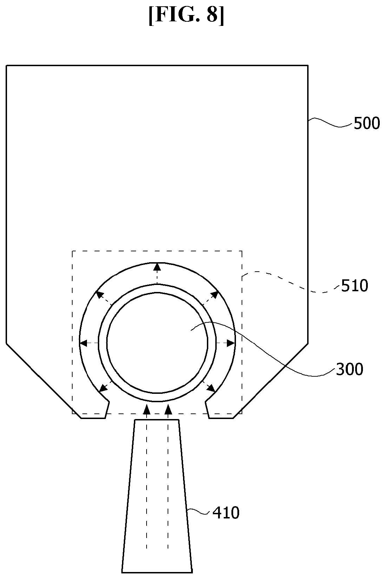

FIG. 8 is a schematic top view of a wafer cleaning apparatus according to an embodiment of the present invention. Referring to FIG. 8, the suction portion 510 may be recessed inwardly of the suction unit 500 and may have a circular cross section so that floating materials are radially drawn into the suction portion. Such a suction portion 510 may improve suction performance by causing an isotropic flow of the floating materials.

Meanwhile, the inner diameter of the suction portion 510 means an inner diameter of a circular shape defined by the cross section of the suction portion 510. In one embodiment, the target position may be located within the inner diameter of the suction portion 510. That is, the center of the inner diameter of the suction portion 510 may be disposed on an optical axis of the objective lens unit 300 or on an optical path of the objective lens unit 300. Alternatively, the center of the inner diameter of the suction portion 510 may be disposed on an optical path of the camera unit 100. In one embodiment, the inner diameter (second diameter) of the suction portion 510 is preferably equal to or greater than an outer diameter (first diameter) of the objective lens unit 300. Meanwhile, all or a lower portion of the objective lens unit 300 may be disposed within the suction portion 510.

Referring again to FIG. 8, the cleaning unit 400 may be disposed to face the suction portion 510 and may be configured to spray dry-ice-state carbon dioxide toward the suction portion 510 during operation of the suction unit 500. For example, the cleaning unit 400 may be disposed at one open side of the suction portion 510. In this case, the cleaning unit 400 may generate anisotropic airflow such that floating materials are guided toward the suction portion 510.

Further, as described above, the cleaning unit 400 may cool the surface of the flat substrate W including a wafer or a mask during the foreign material removal process performed by the laser unit 200 through spraying of the cooling gas. For example, the cooling gas sprayed by the cleaning unit 400 may be reflected from the surface of the flat substrate W including a wafer or a mask and guided toward the suction portion 510.

While preferred embodiments of the present invention have been described above, the present invention is not limited to the embodiments disclosed herein, and various modifications may be made without departing from the scope of the appended claims.

## Claims

1. A cleaning apparatus comprising:
a camera unit configured to capture an image of a surface of a flat substrate including a wafer or a mask;
a laser unit configured to irradiate a laser beam onto a target position when a target position to which a foreign material is attached is identified through the camera unit;
a cleaning unit configured to spray gas toward the target position and a surrounding region thereof; and
a suction unit configured to suction floating materials generated by the laser unit and/or the cleaning unit.

2. The cleaning apparatus of claim 1,
wherein the cleaning unit is configured to detach the foreign material by rapidly contracting and subsequently rapidly expanding the foreign material through physical collision therewith.

3. The cleaning apparatus of claim 1,
wherein the cleaning unit is configured to remove organic foreign materials, and
the laser unit is configured to remove foreign materials including organic foreign materials that are not removed by the cleaning unit.

4. The cleaning apparatus of claim 1,
wherein, during a foreign material removal process performed by the laser unit,
the cleaning unit is configured to spray solid-state carbon dioxide to cool the flat substrate and to simultaneously blow away floating materials generated during the foreign material removal process while preventing thermal damage to the flat substrate.

5. The cleaning apparatus of claim 1, further comprising:
an objective lens unit disposed on an optical path on which an optical axis of the laser unit and an optical axis of the camera unit coincide.

6. The cleaning apparatus of claim 1,
wherein one side of the suction unit includes a suction portion recessed inwardly and having a circular cross section so that floating materials are radially drawn into the suction portion.

7. The cleaning apparatus of claim 6,
wherein a center of an inner diameter of the suction portion is disposed on an optical path of the camera unit, and
the cleaning unit is disposed to face the suction portion and is configured to spray solid-state carbon dioxide toward the suction portion during operation of the suction unit.
